# EUROPEAN PATENT SPECIFICATION

(11) **EP 2 492 699 B1**
(45) Date of publication and mention of the grant of the patent: **31.07.2013**
(21) Application number: 11155309.5
(22) Date of filing: 22.02.2011
(51) Int. Cl.: G01R 27/28, G01R 31/02

(54) **Automatic detection of ground line in a video cable**
Automatische Erkennung der Erdungsleitung in einem Videokabel
Détection automatique d'une ligne au sol dans un câble vidéo

(43) Date of publication of application: 29.08.2012
(73) Proprietor: Research In Motion Limited, Waterloo, ON N2L 3W8 (CA)
(72) Inventor: Poulsen, Jens Kristian, Waterloo Ontario N2L 3W8 (CA)
(74) Representative: Moore, Barry

(56) References cited:
- EP-A1- 1 752 777
- EP-A1- 1 991 029
- JP-A- 9 331 209
- JP-A- 2006 338 957
- US-A- 3 158 806
- US-A1- 2004 206 528
- US-A1- 2005 264 373
- US-A1- 2008 207 061

## Description

The present disclosure is generally directed at cable detection and more specifically is directed at a method and system for automatic detection of a ground line in a video cable.

Mobile device use has continued to increase over the years with new applications and functionality continually being incorporated within these devices. The introduction of these new applications and functionality requires the devices themselves to be updated in order to handle new requirements associated with these applications and functionality.

In some new applications or functionality, cables, such as video cables are necessary to fully enhance the usability of these applications or functionality. In order to connect the video cable with the device, the video cable is typically connected via the insertion of a jack into a device port. Currently, mobile devices are designed to receive video cables that are designed to be compatible with the device. Therefore, users are restricted to using video cables, and associated hardware, that are designed for the specific device and the device is unable to interact with other video cables (and associated peripherals). When supporting video over the jack, it is of interest to support multiple cable types.

The use of video cables requires a ground line to be determined in order to allow the cable to operate correctly. In this context, a ground is not necessarily earth potential, and a "ground line" need not be electrically connected to the Earth. Rather, ground basically connotes a node that is maintained at a reference voltage that is substantially constant with respect to other voltages. When video cables, having LEFT/RIGHT/GND/VIDEO or LEFT/RIGHT/VIDEO/GND connections, are connected to a mobile device, there is no certainty that the ground line can be correctly selected. In fact, there are typically two lines which may represent the ground line and therefore a fifty-fifty chance that the correct line is selected. If the device is not correctly grounded, signals can not be transmitted over the video cable and therefore, operation of the cable (and connected peripheral) is unavailable and no video is available to the user.

US 2008/0207061 discloses a signal transmission cable adapted to be used in a mobile device and including L and R audio lines as well as further lines including a ground line.

The present invention provides a method of determining a ground line within a video cable as recited in claim 1 and a system adapted to detect a ground line within a cable as recited in claim 8. Embodiments of the invention are described in the dependent claims.

Therefore, there is provided a method and apparatus for automatic detection of a ground line in a video cable and for detection of the cable itself.

### GENERAL

In one aspect, there may be provided a signal generator, a preamplifier with wide bandwidth and a threshold detector and a switch matrix in order to detect and correctly select the correct ground line. The cable itself can be detected without or with the use of a switch matrix.

In another aspect, there may be provided a signal generator, a preamplifier with a wide bandwidth and a threshold detector in order to detect the presence of the cable itself.

In yet another aspect, there may be provided a method of determining a ground signal line within a video cable, the video cable including a left audio line, a right audio line, a third line and a fourth line, the method comprising connecting one of the third or fourth line to ground; transmitting a high frequency signal over the other of third and fourth line; measuring outputs of the left audio line or the right audio line; and determining the ground signal line based on the measured outputs.

### BRIEF DESCRIPTION OF THE DETAILED DRAWINGS

Embodiments of the present invention will now be described, by way of example only, with reference to the attached Figures, wherein:

Figure 1 is a schematic diagram of a mobile communication device;

Figure 2 is a more detailed schematic view of the mobile communication device;

Figure 3 is a schematic diagram of a system for automatic detection of a ground line in a video cable;

Figures 4a and 4b are schematic diagrams of responses to the system for automatic detection of a ground line in a video cable;

Figure 5 is a flowchart outlining a method of detecting a ground line in a video cable; and

Figures 6a and 6b are schematic diagrams of automatic detection of cables.

### DETAILED DESCRIPTION

The current disclosure is directed at a method and system for using the parasitic properties of a video cable in order to determine a ground line between multiple ground configurations. In this manner, any video cable can be inserted into a mobile communication device and does not have to be a video cable that is specifically designed to be compatible with the device.

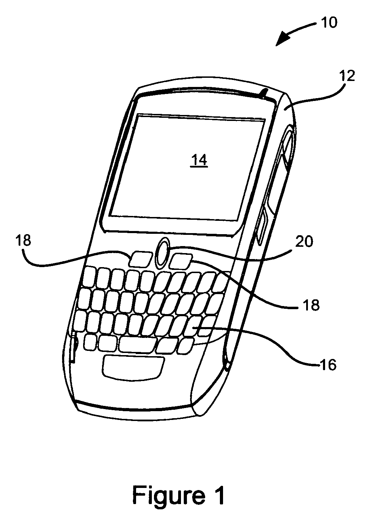

Turning to Figure 1, a schematic diagram of a mobile communication device is shown. The mobile communication device 10 has a body 12 which includes a display screen 14, a keyboard/keypad 16, a set of buttons 18 and a trackball 20. It will be understood that the trackball 20 is representative of a user-operated pointing or input device, which could also be presented as a joystick, scroll wheel, roller wheel, mouse or touchpad or the like, or another button. As will be further understood by one skilled in the art, the device 10 includes other parts which are not shown or described. The mobile communication device 10 also includes at least one port for receiving a jack, but this is not shown in Figure 1.

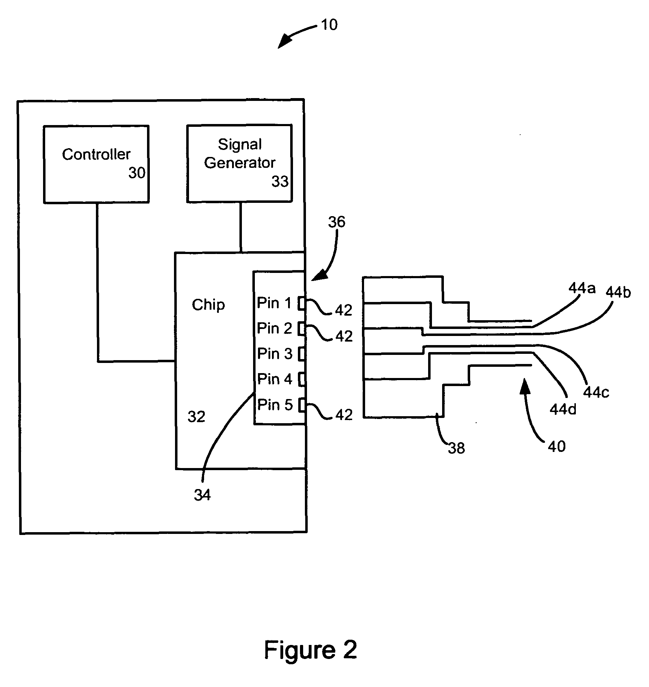

Turning to Figure 2, the mobile communication device 10 further includes a controller, or processor, 30 which is connected to a chip 32 which is integrated within the communication device 10. A signal generator, such as a voltage source, 33 is also connected to the chip 32. The chip 32 includes a switch matrix and jack configuration detect portion 34 which is integrated with a port 36 for receiving a jack 38 associated with a cable 40, such as a video cable. The switch matrix 34 includes a plurality of individual input and output ports 42 for receiving and transmitting signals with corresponding wires 44 within the jack 38. Pin port PIN5 input detects the insertion of the cable by the opening or closing of a mechanical switch, when the plug or jack 38 is inserted. If pin port PIN5 is broken or absent, it is possible to detect the insertion of the cable itself by detecting a capacitance of the cable itself, as described in more detail below. As will also be discussed below, one or more contacts (such as between a pin port and a signal line) can be connected. In this context, "connected" does not necessarily refer to physical contact or proximity—although the contacts may be physically close to or touching one another—but to the electrical connection whereby a signal in one contact results in a signal in the other. Such electrical connection may be completed or broken by affecting a current path (e.g., with the switch matrix 34) rather than by changing the physical relationship of one contact to another.

The wires or lines 44 within the jack 38 represent signal lines, such as audio and video lines, with one wire 44a representing a right audio line, one wire 44b representing a left audio line and then a pair of lines 44c and 44d providing a ground line and a video line. Depending on how the video cable 40 is set up, the ground line may be provided on the line 44c which is connected to pin port PIN3 and the video line provided on line 44d which is connected to port pin PIN4 or vice versa. In order for the controller 30 to communicate with the video cable 40, a determination of which of the pair of lines is the ground line and which of the pair of lines is the video line is necessary. The ground line is connected to a ground reference voltage.

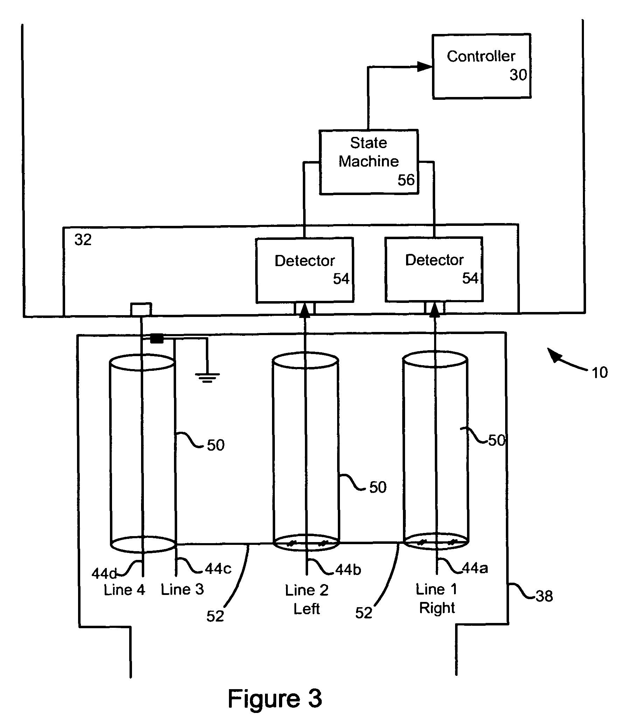

In one embodiment of ground line detection, the detection is achieved by sending out a high frequency AC signal on one of the signal lines and receiving a return signal on the ground line or vice-versa. The presence of a cable results in a different transfer function between the signal generator and a preamplifier. Also, there may be parasitic components within the device or electromagnetic interference (EMI) filtering components that may give rise to an output signal even with no cable present. Therefore, a threshold value needs to be selected accordingly as shown in an example with respect to Figure 3. Alternatively, the jack 38 can be a single prong with the wires 44 implemented as rings surrounding the jack prong.

Turning to Figure 3, a more detailed schematic of components of an apparatus for automatic detection of a ground line in a video cable is shown. As can be seen, three of the wires 44 within the jack 38 are schematically illustrated with a ground shield 50 enclosing each wire. These enclosed wires are the ones which transmit either video or audio signals. As will be understood, with respect to the lines 44c and 44d, from the viewpoint of the video cable, the ground line is line 44c and the video line is 44d. However from the mobile communication device point of view, it is unknown whether the ground line is connected to pin port PIN3 or pin port PIN4 as video cables have different internal implementations.

The ground shields 50 are coupled together via ground shield wires 52 which electrically connect each of the ground shields 50 together. The ground shields 50 provide protection for the wires and serve as conduits, or conductors, for grounding signals.

Detectors 54 are connected to the output of wires 44a and 44b to monitor signals being transmitted over the wires in response to signals transmitted over lines 44c or 44d (as will be discussed in further detail below). The detectors 54 can be discrete components within the mobile device but are preferably implemented on the chip 32. Each detector 54 is connected to a state machine 56, preferably located on the chip 32, to transmit signals representing the measurements recorded by the detectors 54. The detectors 54 may detect or measure any type of electrical characteristic of the signal. In the preferred embodiment, the detectors 54 measure a voltage. The state machine 56, which can be implemented within the controller 30, transmits the results of the signals detected by the detectors 54 to the controller 30 so that the controller can determine which of lines 44c or 44d is the ground line and which is the video line. In general, the state machine 56 is a deciding circuit, which receives inputs from the detectors 54, and determines what condition or conditions are indicated by those inputs (such as whether a particular state is present or absent), and then transmits a signal to the controller 30 as a function of that decision.

The ground shields 50 are coupled to each other and therefore certain characteristics are inherent in this system. As shown, line 44d is isolated from the ground shields 50.

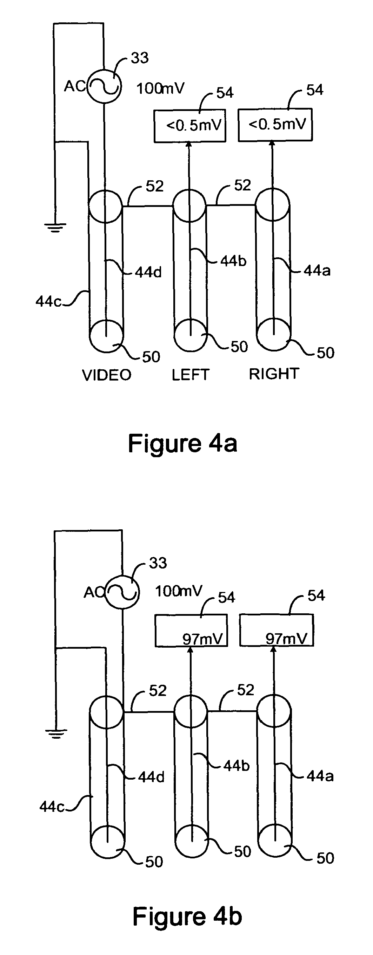

Turning to Figures 4a and 4b, schematic diagrams of the response from lines 44a and 44b to the transmission of a high frequency signal, such as an AC signal, over either line 44c or 44d is shown. In this disclosure, there is no upper or lower limit on what may be deemed to be a "high frequency" signal, but in general, a high frequency signal is typically a signal substantially high enough to be measurably affected by various capacitances, such as those described below. A high frequency signal may further have one or more frequency components of such magnitude that they may be readily detected as being the high frequency signal. When any video cable 40 is inserted into the device 10, the video cable has certain parasitic characteristics which can be used to assist in determining which of lines 44c and 44d is the ground line and which is the video line (from the viewpoint of the mobile device 10).

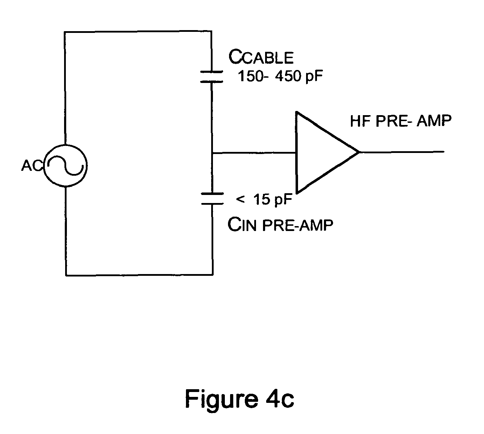

Figures 4a and 4b provide two schematic diagrams showing expected measurements at the audio lines 44a and 44b when a high frequency signal is transmitted over one of the ground line or the video line (from the viewpoint of the video cable) assuming a cable length of about 3 meters. Since the load is much smaller than the capacitance of the video cable, almost the entire voltage can be observed or detected at the load. Figure 4c provides a simplified schematic of Figure 4b.

By grounding one of the lines 44c or 44d and then transmitting an AC signal over the other of the two lines, the impedance in response to the AC signal may be used to distinguish the ground line from the video line (from the viewpoint of the device). By transmitting an AC signal through the actual video line (from the viewpoint of the video cable) and grounding the ground line (from the viewpoint of the video cable), very little signal will leak to the audio lines 44a or 44b since the parasitic elements are relatively small as schematically shown in Figure 4a.

Alternatively, by transmitting an AC signal through the actual ground line and grounding the video line (both from the viewpoint of the video cable), a large amplitude signal can be observed or detected on both audio lines 44a and 44b as schematically shown in Figure 4b.

The reason for this is that all three ground shields 50, or shielded connections, share the same ground connection. By measuring the output or output voltages of the audio lines 44a and 44b in view of a load within the video cable, such as, but not limited to, a low capacitance pre-amplifier, a strong and reliable signal can be obtained when a signal is transmitted over the ground line (from the viewpoint of the video cable).

The output voltage, or signal, which is observed, or detected, over the audio lines 44a or 44b can be calculated as:
Vout = Vsource * Ccable/ (Ccable + Cpre_amp)
   where V represents voltage and C represents capacitance.

For Ccable >> Cpre_amp, Vout is approximate equal to Vsource, i.e. a strong signal that is easy to detect.

As an example, during experimental testing, with a 100 mV AC signal at a frequency of 1 MHz (a lower or higher frequency could also be used) being generated by the signal generator 33 and a three meter long video cable 40, a 97 mV signal was observed or detected using a 15 pF probe and a cable with capacitance of about 450 pF when the video line (from the viewpoint of the video cable) was grounded and the signal was transmitted over the ground line (from the viewpoint of the video cable). The experiment was repeated with a two meter cable, with virtually the same result.

In practice, the pre-amplifier may be implemented in CMOS with a typical input capacitance (including PCB stray capacitance) of less than 20 pF. The signal could be mixed with the AC source itself before or after the pre-amplifier in order to remove any DC-offset problems. If the AC signal is of a high magnitude, it should not be necessary to perform this step.

In yet another configuration, the lines may represent a digital audio signal and two video outputs, where the cable itself is detected by capacitive detection.

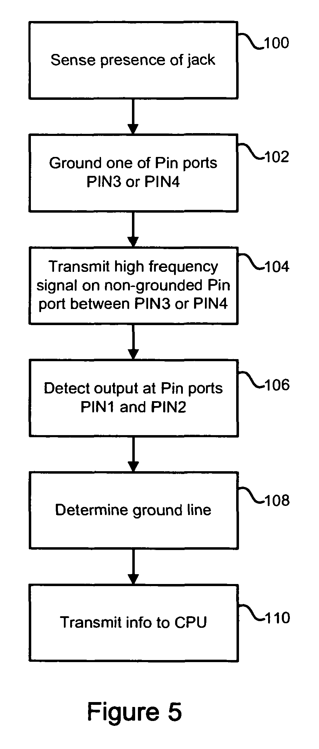

Turning to Figure 5, a flowchart outlining a method of automatic ground line detection in a video cable is shown. In operation, from the video cable point of view, video signals are typically transmitted over the video line. However, when a video cable jack is inserted into the port of the mobile device, it is not always known to which PIN port the video signal line is connected (from the mobile communication device point of view). The video line may be connected to either pin port PIN3 or pin port PIN4. This is problematic since video signals may not be transmitted over the ground line and therefore a determination is required to see over which pin port the video signals are to be transmitted, or, in other words, the pin port which is connected to the video line

The method is initiated once the insertion of the jack of the video cable into the port is detected 100 whereby the individual lines 44 are connected to associated pin ports. In one embodiment, this is achieved by detecting the presence of the jack 38 on pin port PIN5 of the switch matrix and jack configuration detect 34. Alternatively, internal device logic may assist in determining or may determine when the jack is inserted based on the capacitance of the cable itself.

As discussed above, when the jack is inserted into the port, there is a line within the jack that corresponds with each of the pin ports 42 in the switch matrix 34. Typically, pin port PIN1 and pin port PIN2 receive the audio lines 44a and 44b which are characterized as Left audio and Right audio while the pin port PIN5 is used for detecting the presence of the jack itself. With respect to pin ports PIN3 and PIN4, one of these pin ports is connected to the ground line while the other is connected to the video line.

After the presence of the jack is detected 100, one of pin port PIN3 or pin port PIN4 is grounded 102 by connecting the line to a ground reference voltage and then an AC signal, preferably high frequency, is transmitted 104 by the signal generator on the other of pin port PIN3 or pin port PIN4. In the preferred embodiment, the AC signal is generated by the signal generator 33. The high frequency signal is then propagated through the video cable 40. As will be understood, the AC signal may be a sine wave or a square wave although other signals are contemplated.

The transmission of the AC signal results in activity on the Left and Right audio lines 44a and 44b in response to the signal, which are measured as a measured output voltage. The signals transmitted over the audio lines (lines 44a and 44b) are then detected or read 106 over pin port PIN1 and pin port PIN2 by the detectors 54. The audio lines 44a and 44b are kept in a high impedance (tri-state) mode when the measurements are taken in order to minimally affect the measurement.

From these measurements, the ground line can be determined 108. As the AC signal will couple very little to the audio lines 44a and 44b when the high frequency signal is transmitted over or through the video line, if the readings, or measurements on pin port PIN1 and pin port PIN2 are low (such as less than 30% of the original AC signal, or within the threshold associated with the parasitic components of the system), then the pin port over which the high frequency signal was transmitted is designated as being connected to the video line (from the mobile device point of view). Alternatively, as the AC signal has a very good coupling to the audio lines 44a and 44b through the ground line, if the readings from pin port PIN1 and pin port PIN2 are high (such as greater than 30% of the original AC signal, or within the threshold associated with the parasitic components of the system), then the pin port line over which the high frequency signal was transmitted is designated as being connected to the ground line (from the viewpoint of the mobile device).

In one embodiment of the state machine, if the measured voltage signals from both detectors 54 are above a certain threshold (with reference to the transmitted AC signal), the state machine accepts these signals and transmits a signal to the processor indicating which of lines 44c or 44d is the ground line or the video line 110 or directly configures the switch matrix to identify the ground and video lines without intervention from the processor. The state machine 56 may also simply confirm that a condition has been met. The processor may receive the status of the pin selection by an interrupt or logic pin signaling an event or the processor can poll the device to ask for status. In either case, the correct ground selection can either be made automatically by the state machine or by the processor. Any measured voltage signals which are lower than the threshold are rejected by the state machine and a signal is transmitted to the controller indicating which of lines 44c or 44d is the ground line or the video line. As will be understood, the state machine can be set up in an opposite manner whereby it accepts signals which are below the threshold and rejects measured voltage signals which are above the threshold. As can be seen, with the difference between the readings (< 1% vs >95%), a threshold such as 30% of the original signal value may be selected to allow for a margin of error, although other threshold values may be selected. In one embodiment, the threshold may depend on external parasitic components such as stray capacitance, EMI filtering components, etc. such that the threshold is selected so that the state machine will not be triggered falsely by the capacitance of system components, but only by reading from an external cable. This also sets a minimum length for the external cable in order to be reliably detected. Alternatively, other threshold values may be selected and the selection performed in software or the threshold may be optimized in software by implementing multiple thresholds.

After receiving the signal from the state machine, the controller or processor may determine which of pin port PIN3 port or pin port PIN4 port is connected to the video line based on the result from the state machine and the understanding over which pin port the high frequency AC signal was originally transmitted, signals may then be transmitted by the device accordingly in order to interact with the cable.

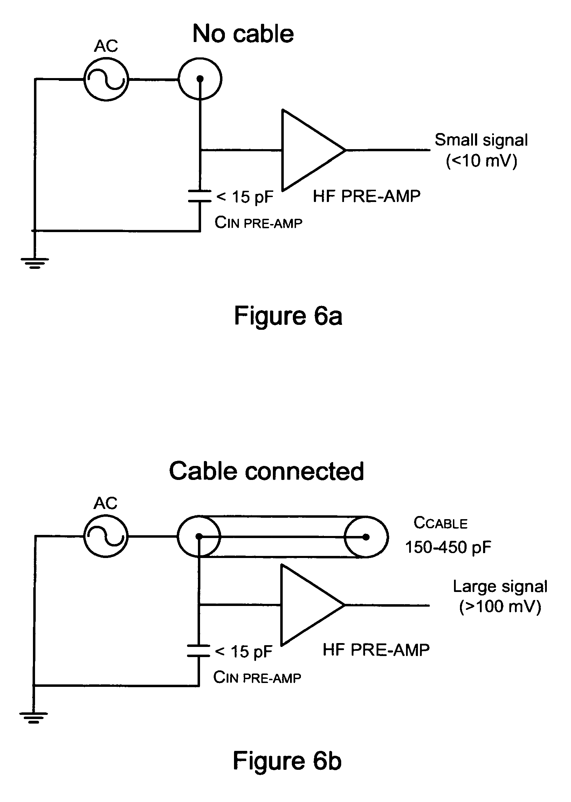

Turning to Figures 6a and 6b, schematic diagrams of automatic cable detection are shown. Along with being able to automatically detect the ground line within a video cable, the system shown in Figure 3 may also be used to assist in the detection of cables when they are inserted into a mobile communication device.

It is possible to detect the presence of the cable itself by measuring a transfer function between a signal generator and a preamplifier connected to the cable. This can also be seen as a method of detecting the impedance load on the output terminals.

The unloaded line transmits a signal of Vout=Cpar/(Cpar+Cpre_amp_in)*Vsignal, where Vsignal is the amplitude of the signal generator, Vout is the output signal, Cpar is the parasitic capacitance and Cpre_amp_in is the input capacitance of the preamplifier. When the output port/terminals are loaded with cable capacitance, the equation is changed to Vout=(Cpar+Ccable)/(Cpar+Ccable+Cpre_amp_in), where Ccable is the cable capacitance. It is possible to detect this change since the latter value is always larger than the first output voltage.

Therefore, in order to determine if a cable has been connected, a signal is transmitted by the signal generator 33 to the switch matrix and jack detect portion 34. The presence or lack of presence of a cable provides a response signal which can be monitored by the state machine or the processor itself by measuring the output level from the pre-amplifier.

If a low signal reading is detected by the processor, the processor can then determine or confirm that no cable is currently plugged in to the mobile communication device. Alternatively, if a high frequency signal reading is detected by the processor, the processor can confirm that presence of a cable and can then proceed to determine which of the signal lines represents the ground line, as outlined above.

This system provides another method of detecting the presence of a cable if other device hardware, such as a headset detection switch is broken or not present.

Typically a chip connected to the headset interface lines detects a cable and then signal an interrupt to the processor in order to indicate that attention is needed. The processor would then query the headset chip and identify that a cable has been plugged in. The testing for a cable may be done at periodic intervals in the range of around 500 ms in order to minimize the current consumption and provide the user a reasonable response time. The testing could complement the insertion detection pin port (PIN5) or be used by itself, in case this pin port is non-functional or missing, with the cost of a slightly increased power consumption.

In the preceding description, for purposes of explanation, numerous details are set forth in order to provide a thorough understanding of the embodiments of the disclosure. However, it will be apparent to one skilled in the art that some or all of these specific details may not be required in order to practice the disclosure. In other instances, well-known electrical structures and circuits are shown in block diagram form in order not to obscure the disclosure. For example, specific details are not provided as to whether the embodiments of the disclosure described herein are as a software routine, hardware circuit, firmware, or a combination thereof.

The above-described embodiments of the disclosure are intended to be examples only. Alterations, modifications and variations can be effected to the particular embodiments by those of skill in the art without departing from the scope of the invention, which is defined by the claims appended hereto. As used herein, the term "including" is not limiting of the set but indicates an illustrative group.

## Claims

1. A method of determining a ground line within a video cable, the video cable including a left audio line, a right audio line, a third line and a fourth line, the method comprising:
connecting one of the third or fourth line to a ground reference voltage;
transmitting a high frequency signal over the other of the third or fourth lines;
measuring output voltages of the left audio line or the right audio line; and
determining the ground line based on the measured outputs.

2. The method of Claim 1 further comprising detecting a presence of the video cable before connecting one of the third or fourth signal line to the ground reference voltage.

3. The method of Claim 1 or Claim 2 wherein the ground line is determined as the line over which the high frequency signal was transmitted if the measured output voltages are approximately equal to an output voltage of the high frequency signal.

4. The method of any one of Claims 1 to 3 wherein the ground line is determined as the line which was connected to the ground reference voltage if the measured output voltages are less than the voltage of the high frequency signal.

5. The method of any preceding Claim wherein determining the ground line comprises:
transmitting the measured outputs to a state machine;
receiving an output of the state machine; and
determining over which line the high frequency signal was transmitted.

6. The method of Claim 5 wherein if the output of the state machine is 1, the line over which the high frequency signal was transmitted is determined as the video line.

7. The method of Claim 5 or Claim 6 wherein if the output of the state machine is 0, the line over which the high frequency signal was transmitted is determined as the video line.

8. A system adapted to detect a ground line within a cable when the cable has been inserted into a mobile device communication port, the cable including a left audio line, a right audio line, a third line and a fourth line, the system comprising:
a switch matrix and jack detect;
a set of pin ports located within the switch matrix adapted to receive the left audio line, the right audio line, the third line and the fourth line;
a signal generator adapted to transmit an AC signal;
a set of detectors adapted to detect outputs of the left audio line and the right audio line in response to transmission of the AC signal; and
a processor adapted to detect the ground line based on the outputs detected by the detectors;
wherein after a cable is detected, one of the third or fourth line is connected to a ground reference voltage and the AC signal is transmitted over the other of the third or fourth line.

9. The system of Claim 8 wherein the set of pin ports includes a port for detecting a presence of the cable.

10. The system of Claim 9 wherein the presence of the cable is detected by measuring a parasitic capacitance of the cable between at least one of the signal lines and the ground reference voltage.

11. The system of Claim 9 wherein the presence of the cable is detected by measuring a parasitic capacitance of the cable between at least two signal lines.

12. The system of any one of Claims 8 to 11 further comprising a state machine for receiving the outputs from the set of detectors and for transmitting a result of the outputs to the processor.

13. The system of any one of Claims 8 to 12 further comprising a state machine for setting up the switch matrix and jack detect and for signaling outputs to the processor.

## Patentansprüche

1. Ein Verfahren zum Bestimmen einer Masseleitung in einem Videokabel, wobei das Videokabel eine linke Audio-Leitung, eine rechte Audio-Leitung, eine dritte Leitung und eine vierte Leitung umfasst, wobei das Verfahren aufweist:
Verbinden einer der dritten oder vierten Leitung mit einer Masse-Referenzspannung;
Übertragen eines Hochfrequenzsignals über die andere der dritten oder vierten Leitungen;
Messen von Ausgangsspannungen der linken Audio-Leitung oder der rechten Audio-Leitung; und
Bestimmen der Masseleitung basierend auf den gemessenen Ausgängen.

2. Das Verfahren gemäß Anspruch 1, das weiter aufweist ein Erfassen eines Vorhandenseins des Videokabels vor einem Verbinden einer der dritten oder vierten Signalleitung mit der Masse-Referenzspannung.

3. Das Verfahren gemäß Anspruch 1 oder Anspruch 2, wobei die Masseleitung als die Leitung bestimmt wird, über die das Hochfrequenzsignal übertragen wird, wenn die gemessenen Ausgangsspannungen ungefähr gleich sind zu einer Ausgangsspannung des Hochfrequenzsignals.

4. Das Verfahren gemäß einem der Ansprüche 1 bis 3, wobei die Masseleitung als die Leitung bestimmt wird, die mit der Masse-Referenzspannung verbunden ist, wenn die gemessenen Ausgangsspannungen niedriger sind als die Spannung des Hochfrequenzsignals.

5. Das Verfahren gemäß einem vorhergehenden Anspruch, wobei das Bestimmen der Masseleitung aufweist:
Übertragen der gemessenen Ausgänge an eine Zustandsmaschine;
Empfangen eines Ausgangs der Zustandsmaschine; und
Bestimmen, über welche Leitung das Hochfrequenzsignal übertragen wurde.

6. Das Verfahren gemäß Anspruch 5, wobei, wenn der Ausgang der Zustandsmaschine 1 ist, die Leitung, über die das Hochfrequenzsignal übertragen wurde, als die Video-Leitung bestimmt wird.

7. Das Verfahren gemäß Anspruch 5 oder Anspruch 6, wobei, wenn der Ausgang der Zustandsmaschine o ist, die Leitung, über die das Hochfrequenzsignal übertragen wurde, als die Video-Leitung bestimmt wird.

8. Ein System, das ausgebildet ist zum Erfassen einer Masseleitung in einem Kabel, wenn das Kabel in einen Kommunikationsanschluss einer mobilen Vorrichtung eingeführt wurde, wobei das Kabel eine linke Audio-Leitung, eine rechte Audio-Leitung, eine dritte Leitung und eine vierte Leitung umfasst, wobei das System aufweist:
eine Schalter-Matrix und Anschluss-Erfassung;
einen Satz von Stift-Anschlüssen, die sich in der Schalter-Matrix befinden, die ausgebildet ist zum Aufnehmen der linken Audio-Leitung, der rechten Audio-Leitung, der dritten Leitung und der vierten Leitung;
einen Signalgenerator, der ausgebildet ist zum Übertragen eines AC-Signals;
einen Satz von Detektoren, der ausgebildet ist zum Erfassen von Ausgängen der linken Audio-Leitung und der rechten Audio-Leitung in Reaktion auf die Übertragung des AC-Signals; und
einen Prozessor, der ausgebildet ist zum Erfassen der Masseleitung basierend auf den Ausgängen, die von den Detektoren erfasst werden;
wobei, nachdem ein Kabel erfasst wird, eine der dritten oder vierten Leitung mit einer Masse-Referenzspannung verbunden wird und das AC-Signal über die andere der dritten oder vierten Leitung übertragen wird.

9. Das System gemäß Anspruch 8, wobei der Satz von Stift-Anschlüssen einen Anschluss zum Erfassen eines Vorhandenseins des Kabels umfasst.

10. Das System gemäß Anspruch 9, wobei das Vorhandensein des Kabels durch Messen einer parasitären Kapazität des Kabels zwischen zumindest einer der Signalleitungen und der Masse-Referenzspannung erfasst wird.

11. Das System gemäß Anspruch 9, wobei das Vorhandensein des Kabels durch Messen einer parasitären Kapazität des Kabels zwischen zumindest zwei Signalleitungen erfasst wird.

12. Das System gemäß einem der Ansprüche 8 bis 11, das weiter eine Zustandsmaschine aufweist zum Empfangen der Ausgänge von dem Satz von Detektoren und zum Übertragen eines Ergebnisses der Ausgänge an den Prozessor.

13. Das System gemäß einem der Ansprüche 8 bis 12, das weiter eine Zustandsmaschine aufweist zum Einrichten der Schalt-Matrix und der Anschluss-Erfassung und zum Signalisieren von Ausgängen an den Prozessor.

## Revendications

1. Procédé de détermination d'une ligne de masse dans un câble vidéo, le câble vidéo comportant une ligne audio gauche, une ligne audio droite, une troisième ligne et une quatrième ligne, le procédé comprenant le fait :
de connecter l'une de la troisième ou quatrième ligne à une tension de référence de masse ;
de transmettre un signal haute fréquence par l'autre des troisième ou quatrième lignes ;
de mesurer des tensions de sortie de la ligne audio gauche ou de la ligne audio droite ; et
de déterminer la ligne de masse sur la base des sorties mesurées.

2. Procédé de la revendication 1, comprenant en outre la détection de la présence du câble vidéo avant de relier l'une de la troisième ou quatrième ligne de signal à la tension de référence de masse.

3. Procédé de la revendication 1 ou 2, dans lequel la ligne de masse est déterminée comme étant la ligne par laquelle le signal haute fréquence a été transmis si les tensions de sortie mesurées sont approximativement égales à une tension de sortie du signal haute fréquence.

4. Procédé de l'une quelconque des revendications 1 à 3, dans lequel la ligne de masse est déterminée comme étant la ligne qui a été reliée à la tension de référence de masse si les tensions de sortie mesurées sont inférieures à la tension du signal haute fréquence.

5. Procédé de l'une quelconque des revendications précédentes, dans lequel la détermination de la ligne de masse comprend le fait :
de transmettre les sorties mesurées à une machine à états ;
de recevoir une sortie de la machine à états ; et
de déterminer la ligne par laquelle le signal haute fréquence a été transmis.

6. Procédé de la revendication 5, dans lequel si la sortie de la machine à états est égale à 1, la ligne par laquelle le signal haute fréquence a été transmis est déterminée comme étant la ligne vidéo.

7. Procédé de la revendication 5 ou de la revendication 6, dans lequel si la sortie de la machine à états est égale à 0, la ligne par laquelle le signal haute fréquence a été transmis est déterminée comme étant la ligne vidéo.

8. Système conçu pour détecter une ligne de masse dans un câble lorsque le câble a été inséré dans un port de communication de dispositif mobile, le câble comportant une ligne audio gauche, une ligne audio droite, une troisième ligne et une quatrième ligne, le système comprenant :
un élément de détection de matrice de commutation et de prise ;
un ensemble de ports à broches situés dans la matrice de commutation conçus pour recevoir la ligne audio gauche, la ligne audio droite, la troisième ligne et la quatrième ligne ;
un générateur de signal conçu pour transmettre un signal de courant alternatif ;
un ensemble de détecteurs conçus pour détecter des sorties de la ligne audio gauche et de la ligne audio droite en réponse à la transmission du signal de courant alternatif ; et
un processeur conçu pour détecter la ligne de masse sur la base des sorties détectées par les détecteurs ;
dans lequel, après qu'un câble est détecté, l'une de la troisième ou quatrième ligne est reliée à une tension de référence de masse et le signal de courant alternatif est transmis par l'autre de la troisième ou quatrième ligne.

9. Système de la revendication 8, dans lequel l'ensemble de ports à broches comporte un port pour détecter la présence du câble.

10. Système de la revendication 9, dans lequel la présence du câble est détectée par la mesure d'une capacité parasite du câble entre au moins l'une des lignes de signal et la tension de référence de masse.

11. Système de la revendication 9, dans lequel la présence du câble est détectée par la mesure d'une capacité parasite du câble entre au moins deux lignes de signal.

12. Système de l'une quelconque des revendications 8 à 11, comprenant en outre une machine à états pour recevoir les sorties de l'ensemble de détecteurs et pour transmettre un résultat des sorties au processeur.

13. Système de l'une quelconque des revendications 8 à 12, comprenant en outre une machine à états pour installer l'élément de détection de matrice de commutation et de prise et pour signaler des sorties au processeur.
